# EUROPEAN PATENT APPLICATION

(11) **EP 3 712 305 A1**
(43) Date of publication of application: **23.09.2020**
(21) Application number: 18878719.6
(22) Date of filing: 15.11.2018
(51) Int. Cl.: C30B 29/16, C30B 23/06, H01L 21/337, H01L 21/338, H01L 21/365, H01L 29/12, H01L 29/24, H01L 29/778, H01L 29/78, H01L 29/808, H01L 29/812, H01L 29/872

(54) **P-TYPE OXIDE SEMICONDUCTOR FILM AND METHOD FOR FORMING SAME**

(30) Priority: 15.11.2017 JP 2017219760
(71) Applicant: Flosfia Inc., Kyoto 615-8245 (JP)
(72) Inventor: TAKAHASHI Isao, Kyoto-shi Kyoto 615-8245 (JP); MATSUDA Tokiyoshi, Kyoto-shi Kyoto 615-8245 (JP); SHINOHE Takashi, Kyoto-shi Kyoto 615-8245 (JP)
(74) Representative: Gulde & Partner
(86) International application number: PCT/JP2018/042346
(87) International publication number: WO 2019/098295

(57) **Abstract**

An industrially useful p-type oxide semiconductor with an enhanced semiconductor characteristic and a method of forming the p-type oxide semiconductor is provided. By using a metal oxide (for example, iridium oxide) gas as a raw material and conducting a crystal growth on a base with a corundum structure (for example, a sapphire substrate) until a film thickness to be equal to or more than 50 nm, a p-type oxide semiconductor film with a corundum structure includes a film thickness of equal to or more than 50 nm and a surface roughness of equal to or less than 10nm is obtained.

## Description

### TECHNICAL FIELD

The disclosure relates to a p-type oxide semiconductor. The disclosure also relates to a method for forming the p-type semiconductor. The disclosure also relates to a semiconductor device and a semiconductor system using the p-type oxide semiconductor.

### BACKGROUND ART

As a switching device of the next generation achieving high withstand voltage, low losses, and high temperature resistance, semiconductor devices using gallium oxide (Ga₂O₃) with a large band gap attract attention and are expected to be applied to power semiconductor devices including an inverter. Also, gallium oxide is expected to be applied to a light emitting and receiving element such as a light emitting diode (LED) and a sensor, since gallium oxide has a wide band gap. According to Non-Patent Literature 1, such gallium oxide has a band gap that may be controlled by forming mixed crystal with indium or aluminum singly or in combination and such a mixed crystal is extremely attractive materials as InAlGaO-based semiconductors. Here, InAlGaO-based semiconductors refers to InxAlYGazO₃ (0≦X≦2, 0≦Y≦2, 0≦Z≦2, X+Y+Z=1.5∼2.5) can be viewed as the same material system containing gallium oxide.

In recent years, gallium oxide based p-type semiconductors have been studied. For example, Patent Literature 1 describes a base showing p-type conductivity to be obtained by forming a β-Ga₂O₃ based crystal by floating zone method using MgO (p-type dopant source). Also, Patent Literature 2 discloses to form a p-type semiconductor by using an ion implantation of p-type dopant into α-(AlₓGa₁₋ₓ)₂O₃ single crystalline film obtained by Molecular Beam Epitaxy (MBE) method. However, Non-Patent Literature 2 discloses that a p-type semiconductor was not obtained by the methods disclosed in Patent Literatures 1 and 2 (NPL2). In fact, there has been no reports of any success in forming a p-type semiconductor by use of the methods disclosed in Patent Literatures 1 and 2. Therefore, p-type oxide semiconductor and a method of manufacturing a p-type oxide semiconductor have been desired to be realized.

Also, Non-Patent Literatures 3 and 4 disclose that for example, a use of Rh₂O₃ or ZnRh₂O₄ as a p-type semiconductor has been considered. Nevertheless, Rh₂O₃ has a problem with a raw material that tends to be low in concentration especially in deposition process, and a low concentration of the raw material affects deposition. In addition, it has been difficult to produce a single crystal of Rh₂O₃ even if using an organic solvent. Also, even though Hall effect measurement was conducted, Rh₂O₃ and ZnRh₂O₄ were not determined to be p-type or the measurement itself might not be well done. Further, for example, Hall coefficient of these semiconductors were measurement limit (0.2 cm³/C) or less that was not useful at all. Also, since ZnRh₂O₄ has a low mobility and a narrow band gap, ZnRh₂O₄ cannot be used as LED or power devices. Therefore, Rh₂O₃ and ZnRh₂O₄ were not necessarily satisfactory.

0 0 0 1 As a wide band gap semiconductor besides Rh₂O₃ and ZnRh₂O₄, various p-type oxide semiconductors have been investigated. Patent Literature 3 discloses that delafossite or oxychalcogenide are used as p-type semiconductor. However, the semiconductor using delafossite or oxychalcogenide has a mobility of as low as 1 cm²/Vs or less and insufficient electrical properties and thus, the semiconductor using delafossite or oxychalcogenide could not form a p-n junction properly with a next generation n-type oxide semiconductor such as α-Ga₂O₃.

Also, Ir₂O₃ has been conventionally known, for example, to be used as an iridium catalyst as disclosed in Patent Literature 4, and Patent Literature 5 discloses Ir₂O₃ is used as a dielectric, and Patent Literature 6 discloses that Ir₂O₃ is used as an electrode. However, Ir₂O₃ never been known to be used as a p-type semiconductor. Recently, the applicants have researched a use of Ir₂O₃ as a p-type semiconductor.

### Prior art document

### Patent Literature

Patent Literature 1: JP2005-340308A
Patent Literature 2: JP2013-58637A
Patent Literature 3: JP2016-25256A
Patent Literature 4: JPH09-25255A
Patent Literature 5: JPH08-227793A
Patent Literature 6: JPH11-21687A

### Non-Patent Literature

Non-Patent Literature 1: Kaneko, Kentaro, "Fabrication and physical properties of corundum structured alloys based on gallium oxide", Dissertation, Kyoto Univ., March 2013
Non-Patent Literature 2: Tatsuya, Takemoto, EE Times, Japan "power device gallium oxide" Thermal conductivity, p-type overcoming issues and putting it into practical use. [online], Retrieved Jun. 21, 2016, from http://eetimes.jp/ee/articles/1402/27/news028_2.html
Non-Patent Literature 3: NPL 3: F. P. KOFFYBERG et al., "optical bandgaps and electron affinities of semiconducting Rh2O3(I) and Rh2O3(III)", J. Phys. Chem. Solids Vol. 53, No. 10, pp. 1285-1288, 1992
Non-Patent Literature: 4 Hideo Hosono, "Functional development of oxide semiconductor" Physics Research, Electronic version, Vol. 3, No. 1, 031211 (Merger issue of September 2013 and February 2014)

### SUMMARY OF THE DISCLOSURE

### TECHNICAL PROBLEM

It is an object of the disclosure to provide an industrially useful p-type oxide semiconductor with an enhanced semiconductor characteristic. It is also an object of the disclosure to provide a method of forming the p-type oxide semiconductor.

### SOLUTION TO PROBLEM

As a result of earnest examination to achieve the above object, the inventors found that, when forming a p-type oxide semiconductor, by using a metal oxide gas as a raw material and conducting a crystal growth on a base, even if not amorphous, a p-type oxide semiconductor with a thickness of equal to or more than 50 nm and a surface roughness of equal to or less than 10 nm can be obtained. The inventors also found that the obtained p-type oxide semiconductor film can solve the above-mentioned problem.
In addition, after learning the above findings, the inventors have made further research to reach the disclosure.

After learning the above findings, the inventors have made further research to complete the disclosure. That is, the disclosure relates to the followings. 0 0 0 2
[1] An oxide semiconductor film having a p-type electrical conductivity and includes as a major component a metal oxide having a corundum structure, and wherein a surface roughness of the oxide semiconductor film is equal to or less than 100 nm.
[2] The oxide semiconductor film of [1] above, wherein a thickness of the oxide semiconductor film is equal to or more than 50 nm.
[3] The oxide semiconductor film of [1] above, wherein the thickness of the oxide semiconductor film is equal to or more than 100 nm.
[4] The oxide semiconductor film of any one of [1] to [3] above, wherein the metal oxide includes a d-block metal in the periodic table or a metal of Group 13 of the periodic table.
[5] The oxide semiconductor film of any one of [1] to [4] above, wherein the metal oxide includes a metal of Group 9 of the periodic table or the metal of Group 13 of the periodic table.
[6] The oxide semiconductor film of any one of [1] to [5] above, wherein the metal oxide includes iridium.
[7] The oxide semiconductor film of any one of [1] to [6] above, wherein the surface roughness of the oxide semiconductor film is equal to or less than 10 nm.
[8] The oxide semiconductor film of any one of [1] to [7] above, wherein a carrier mobility of the oxide semiconductor film is equal to or more than 1.0 cm²/V·s.
[9] The oxide semiconductor film of any one of [1] to [8] above, wherein a carrier concentration of the oxide semiconductor film is equal to or less than 8 × 10²⁰/cm³.
[10] A method of forming a p-type oxide semiconductor film including: using a metal oxide gas, and conducting a crystal growth on a base having a corundum structure.
[11] The method of [10] above, wherein the metal oxide gas includes a metal of Group 9 of the periodic table or a metal of Group 13 of the periodic table.
[12] The method of [10] or [11] above, wherein the metal oxide gas includes the metal of Group 9 of the periodic table.
[13] The method of any one of [10] to [12] above, wherein the metal oxide includes at least iridium.
[14] The method of any one of [10] to [13] above, wherein a solid-state metal oxide is heated to sublimate into the metal oxide gas.
[15] The method of any one of [10] to [14] above, wherein the crystal growth is conducted under atmospheric pressure.
[16] A semiconductor device including: a semiconductor layer having an oxide semiconductor film of any one of [1] to [9] above, and an electrode.
[17] The semiconductor device of claim [16] above, further including an n-type semiconductor layer including an oxide semiconductor as a major component.
[18] The semiconductor device of [16] or [17] above, wherein the n-type semiconductor layer includes a metal of Group 13 of the periodic table.
[19] The semiconductor device of any one of [16] to [18] above, wherein the semiconductor device is a diode or a transistor.
[20] The semiconductor device of any one of [16] to [19] above, wherein the semiconductor device is SBD, MOSFET, IGBT or JFET.
[21] The semiconductor device of any one of [16] to [20] above, further including a semiconductor-on-insulator (SOI) structure, wherein the SOI structure includes a silicon substrate, and an insulating layer that is embedded on the silicon substrate.
[22] The semiconductor device of [16] to [21] above, wherein the semiconductor device is a power device.
[23] The semiconductor device of [16] to [22] above, wherein the semiconductor device is a power module, an inverter, or a converter.
[24] A semiconductor system including: the semiconductor device of any one of [16] to [23] above.

### ADVANTAGEOUS EFFECTS

A p-type oxide semiconductor film of the disclosure is industrially useful and excellent in semiconductor properties. In addition, the forming method of the disclosure can form the p-type oxide semiconductor film industrially advantageously.

### BRIEF DESCRIPTION OF THE DRAWINGS

Fig.1 is a schematic configuration diagram illustrating an embodiment of a deposition apparatus used in the example.
Fig.2 is a schematic configuration diagram illustrating an embodiment of a deposition apparatus (mist CVD apparatus) used in the comparative example.
Fig.3 is a diagram illustrating the results of XRD measurement results in the example and the comparative example. A horizontal axis represents the diffraction angle (deg.), a vertical axis represents the diffraction strength (arb. unit).
Fig.4 is a diagram illustrating the AFM surface observation result in the example.
Fig.5 is a diagram illustrating the AFM surface observation result in the comparative example.
Fig.6 is a diagram illustrating the observation result of the cross-sectional SEM, (a) illustrates the observation result of the cross-sectional SEM in the example, (b) illustrates the observation results of the cross-sectional SEM of the comparative example.
Fig.7 is a schematic diagram illustrating an embodiment of a Schottky barrier diode (SBD).
Fig. 8 is a schematic diagram illustrating an embodiment of an embodiment of a high-electron mobility transistor (HEMT).
Fig.9 is a schematic diagram illustrating an embodiment of a Metal Oxide Semiconductor Field Effect Transistor (MOSFET).
Fig.10 is a schematic diagram illustrating an embodiment of a Junction Field Effect Transistor (JFET).
Fig.11 is a schematic diagram illustrating an Insulated Gate Bipolar Transistor (IGBT).
Fig.12 is a schematic diagram illustrating an embodiment of a Light Emitting Diode (LED).
Fig. 13 is a schematic diagram illustrating an embodiment of a Light Emitting Diode (LED).
Fig.14 is a schematic diagram illustrating an embodiment of a power source system.
Fig.15 is a schematic diagram illustrating an embodiment of a system device.
Fig.16 is a schematic diagram illustrating an embodiment of a circuit diagram of power source device.
Fig.17 is a schematic diagram illustrating an embodiment a Heterojunction Bipolar Transistor (HBT).
Fig.18 is a schematic diagram illustrating an embodiment of a Metal Oxide Semiconductor Field Effect Transistor (MOSFET).
Fig.19 is a diagram illustrating the results of the I-V measurement in the example.
Fig.20 is a schematic configuration diagram illustrating an embodiment of a deposition apparatus used in the example.
Fig.21 is a schematic configuration diagram illustrating an embodiment of a deposition apparatus used in the example.
Fig.22 is a schematic configuration diagram illustrating the results of XRD measurement results in the example and the comparative example. A horizontal axis represents the diffraction angle (deg.), a vertical axis represents the diffraction strength (arb. unit).
Fig.23 is a schematic configuration diagram illustrating the results of XRD measurement results in the example and the comparative example. A horizontal axis represents the diffraction angle (deg.), a vertical axis represents the diffraction strength (arb. unit).

### DESCRIPTION OF EMBODIMENTS

Hereinafter, preferred embodiments of the disclosure are described.

A p-type oxide semiconductor film of the disclosure is an oxide semiconductor film having a p-type electrical conductivity and includes as a major component a metal oxide having a corundum structure, and a surface roughness (Ra) of the oxide semiconductor is equal to or less than 100 nm. According to one or more embodiments of the disclosure, the surface roughness is preferably 50nm or less, and more preferably 10nm or less. Here, the surface roughness (Ra) is a value obtained by calculating based on JIS B0601, using a surface shape-measurement result for an area of 10 µm square by AFM (Atomic Force Microscopy.

"A metal oxide with a corundum structure" is a metal oxide including a crystalline layer having a corundum structure. The metal oxide with a corundum structure may include a layer other than the crystalline layer having the corundum structure (e.g., an amorphous layer). Further, the crystalline layer having the corundum structure is preferably a single crystal layer, but may be a polycrystalline layer.

A thickness of the p-type oxide semiconductor film is not particularly limited, but is preferably equal to or more than 50nm, more preferably equal to or more than 100nm, and most preferably equal to or more than 1.0µm. According to one or more embodiments of the disclosure, even if the p-type oxide semiconductor film is a thick film, it is possible to obtain the p-type oxide semiconductor film having enhanced surface smoothness.

The p-type oxide semiconductor film normally contains a metal oxide with a corundum structure as a major component. The metal oxide preferably contains a d-block metal or a metal of Group 13 of the periodic table, more preferably contains a metal of Group 9 of the periodic table or a metal of Group 13 of the periodic table, and most preferably contains iridium. The term "major component" herein means that the metal oxide is preferably contained in the p-type oxide semiconductor film at an atomic ratio of equal to or more than 50% in all elements in the p-type oxide semiconductor film, more preferably equal to or more than 70%, further more preferably equal to or more than 90%. According to one or more embodiments of the disclosure, the metal oxide may be contained in the p-type oxide semiconductor film at an atomic ratio of 100 % in the all elements in the p-type oxide semiconductor film. According to an embodiment of the disclosure, it is preferable that the p-type oxide semiconductor film contains a crystal of a metal oxide including iridium, or a mixed crystal of the metal oxide including iridium. "Metal oxide including iridium" herein includes an iridium element and oxygen. According to one or more embodiments of the disclosure, the metal oxide including iridium is preferably Ir₂O₃ and more preferably α-Ir₂O₃. When the metal oxide is a mixed crystal, it is also preferable that the metal oxide is a mixed crystal containing iridium and a metal of Group 2 of the periodic table, a metal of Group 9 other than iridium, or a metal of Group 13. According to the preferred embodiments of the disclosure, as described above, since the p-type oxide semiconductor film with the band gap of equal to or more than 2.4eV, it is possible to exhibit a wider band gap and more enhanced electric properties as a p-type oxide semiconductor. According to one or more embodiments of the disclosure, the band gap of the p-type oxide semiconductor film is preferably 2.0eV or more.

The term "periodic table" herein means the periodic table defined by the International Union of Pure and Applied Chemistry (IUPAC). The term "d-block metal" herein means an element that has electrons that fill the 3d, 4d, 5d, and 6d orbitals. Examples of a d-block metal in the periodic table may include at least one metal selected from among scandium (Sc), titanium (Ti), vanadium (V), chromium (Cr), manganese (Mn), iron (Fe), cobalt (Co), nickel (Ni), copper (Cu), zinc (Zn), yttrium (Y), zirconium (Zr), niobium (Nb), molybdenum (Mo), technetium (Tc), ruthenium (Ru), rhodium (Rh), palladium (Pd), silver (Ag), cadmium (Cd), lutetium (Lu), hafnium (Hf), tantalum (Ta), tungsten (W), rhenium (Re), osmium (Os), iridium (Ir), platinum (Pt), gold (Au), mercury (Hg), lawrencium (Lr), rutherfordium (Rf), dubnium (Db), seaborgium (Sg), bohrium (Bh), hassium (Hs), meitnerium (Mt), darmstadtium (Ds), roentgenium (Rg), and copernicium (Cn).

Examples of the metal of Group 2 of the periodic table include beryllium (Be), magnesium (Mg), calcium (Ca), strontium (Sr), barium (Ba), and a combination of two or more of metals of Group 2. The term "metal except iridium of Group 9" means a metal selected from among metals except iridium of Group 9 of the periodic table. Examples of the metal of Group 9 include cobalt (Co), rhodium (Rh), and a combination of two or more metals thereof. The term "metal of Group 13" is not particularly limited as long as the metal belongs to Group 13 of the periodic table. Examples of the metal of Group 13 of the periodic table include aluminum (Al), gallium (Ga), indium (In), thallium (Ta), and a combination of two or more metals thereof. According to one or more embodiments of the disclosure, the metal preferably includes at least one metal selected from among aluminum (Al), gallium (Ga), and indium (In).

The p-type oxide semiconductor film according to one or more embodiments of the disclosure be preferably obtained by a method described below, and the method of manufacturing a p-type oxide semiconductor is also new and useful and thus, included herein one or more embodiments of the disclosure.

The method of forming the p-type oxide semiconductor film according to one or more embodiments of the disclosure includes, using a metal oxide gas as a raw material, and conducting a crystal growth on a base having a corundum structure. In more detail, for example, a solid substance (e.g., powder) of the metal oxide gas is sublimed (sublimation step), and then crystal growth is conducted on the base having the corundum structure, using the obtained metal oxide gas (crystal growth step).

### (Sublimation process)

In the sublimation step, a solid substance of the metal oxide gas (e.g., powder) is sublimed to form a gaseous state and to, thereby obtaining a metal oxide gas. Examples of the metal oxide gas include a gaseous oxide of a metal that is contained in the p-type oxide semiconductor film, and a valence and the like of the metal oxide is not particularly limited unless it deviates from an object of the disclosure. The valence of the metal oxide be monovalent divalent, trivalent, or tetravalent. According to one or more embodiments of the disclosure, when the p-type oxide semiconductor film includes a metal oxide containing iridium as major component, IrO₂ gas is preferably used as the metal oxide gas. Examples of the sublimation method include heating method. A heating temperature is not particularly limited, but is preferably in a range of from 600°C to 1200°C, more preferably in a range of from 800°C to 1000°C. According to one or more embodiments of the disclosure, it is preferable that the metal oxide gas obtained by sublimation is transported to a base by a carrier gas. A type of the carrier gas is not particularly limited unless it deviates from an object of the disclosure. Examples of the carrier gas include oxygen, ozone, an inert gas such as nitrogen, or argon, or a reducing gas such as a hydrogen gas or a forming gas. According to one or more embodiments of the disclosure, it is preferable to use oxygen as the carrier gas. Examples of the carrier gas that uses oxygen include air, oxygen gas, ozone gas, and in particular, oxygen gas and/or ozone gas are preferable. Further, the carrier gas may contain one or two or more gasses. Also, a diluted gas (e.g., 10-fold diluted carrier gas) and the like may be further used as a second carrier gas. The carrier gas may be supplied from one or more locations. While a flow rate of the carrier gas is not particularly limited, but may be preferably in a range of from 0.01 L/min to 20 L/min and more preferably in a range of from 1 L/min to 10 L/min.

The base is not particularly limited as long as the base has a corundum structure and can support the p-type oxide semiconductor film. The material of the base is not particularly limited as long as the material has a corundum structure, and may be a known base. The base may be an organic compound or an inorganic compound. Examples of the base material include metal oxide having a corundum structure such as sapphire and α-type gallium oxide. The base may be in any shape, and can perform for any shape. Examples of the shape of the base include plate such as flat plate or a disc, fibrous, bar, columnar, prismatic, cylindrical, spiral, spherical and annular. According to one or more embodiments of the disclosure, the base is preferably a substrate. A thickness of the substrate is not particularly limited according to one or more embodiments of the disclosure.

The substrate is not particularly limited as long as the substrate is in the shape of plate and can support the p-type oxide semiconductor film. The substrate may be an insulator substrate, a semiconductor substrate, a metal substrate or a conductive substrate, however, the substrate is preferably an insulator substrate and also preferably a substrate having a metal film on a surface thereof. Examples of the substrate include a substrate including a substrate material with a corundum structure as a major component, a substrate including a substrate material with a β-Gallia structure as a major component or a substrate including a substrate material with a hexagonal structure as a major component. The term "major component" herein means that the substrate preferably contains a substrate material with a particular crystalline structure at an atomic ratio of 50 % or more to all components of a substrate material contained in the substrate. The substrate preferably contains the substrate material with the particular crystalline structure at an atomic ratio of 70 % or more to all components of the substrate material contained in the substrate and more preferably contains at an atomic ratio of 90 % or more. The substrate may contain the substrate material with the particular crystalline structure at an atomic ratio of 100 % to all components of the substrate material contained in the substrate.

### (Crystal growth step)

In the crystal growth step, a crystal growth is conducted in a vicinity of a surface of the base to form a film on a part or all of the surface of the base. A temperature of the crystal growth is preferably lower than the heating temperature in the sublimation step, more preferably equal to or less than 900°C or less, and most preferably in a range of from 500°C to 900°C. The crystal growth may be conducted in any atmosphere of a vacuum, a non-oxygen, atmosphere, a reducing gas atmosphere and an oxygen atmosphere, unless it deviates from an object of the disclosure. The crystal growth may be conducted in any conditions of under an atmospheric pressure, under an increased pressure, and under a reduced pressure, unless it deviates from an object of the disclosure. According to one or more embodiments of the disclosure, it is preferable that the crystal growth is conducted under an oxygen atmosphere, preferably under an atmospheric pressure, and more preferably under an oxygen atmosphere and at atmospheric pressure. "Oxygen atmosphere" is not particularly limited as long as the oxygen atmosphere is an atmosphere in which a crystal of the metal oxide or a mixed crystal of the metal oxide can be formed and is an atmosphere in which oxygen or a compound including oxygen are present. The oxygen atmosphere may be formed, for example, by using a carrier gas including oxygen or by using an oxidant. Further, a film thickness can be set by adjusting a deposition time. According to one or more embodiments of the disclosure, the film thickness is preferably equal to or more than 50nm, more preferably equal to or more than 100nm, and most preferably equal to or more than 1.0µm. The upper limit of the film thickness is not particularly limited, but is preferably 1mm, more preferably 100µm. According to one or more embodiments of the disclosure, the metal oxide gas may contain a p-type dopant to make the metal oxide having corundum structure to be doped by the p-type dopant. Examples of the p-type dopant include Mg, H, Li, Na, K, Rb, Cs, Fr, Be, Ca, Sr, Ba, Ra, Mn, Fe, Co, Ni, Pd, Cu, Ag, Au, Zn, Cd, Hg, Tl, Pb, N, P, and two or more elements thereof. According to one or more embodiments of the disclosure, the p-type dopant is preferably a metal of Group 1 in the periodic table or a metal of Group 2 in the periodic table, more preferably a metal of Group 2 in the periodic table, and most preferably magnesium. Further, according to one or more embodiments of the disclosure, the p-type oxide semiconductor film obtained by the crystal growth process may be annealed.

According to one or more embodiments of the disclosure, the metal oxide gas may be obtained, for example, by evaporating and optionally oxidizing a liquid substance (e.g., mist), of a precursor of the metal oxide gas. In this case, it is preferable that the liquid substance (e.g., mist) of the precursor of the metal oxide gas is mist obtained by atomizing a raw material solution or forming droplets from the raw material solution.

Hereinafter, as another preferred embodiment of a method for forming the p-type oxide semiconductor film, a method for forming a p-type oxide semiconductor film using a metal oxide obtained by evaporating and optionally oxidizing a liquid substance (e.g., mists) of the precursor of the metal oxide is described in more detail.

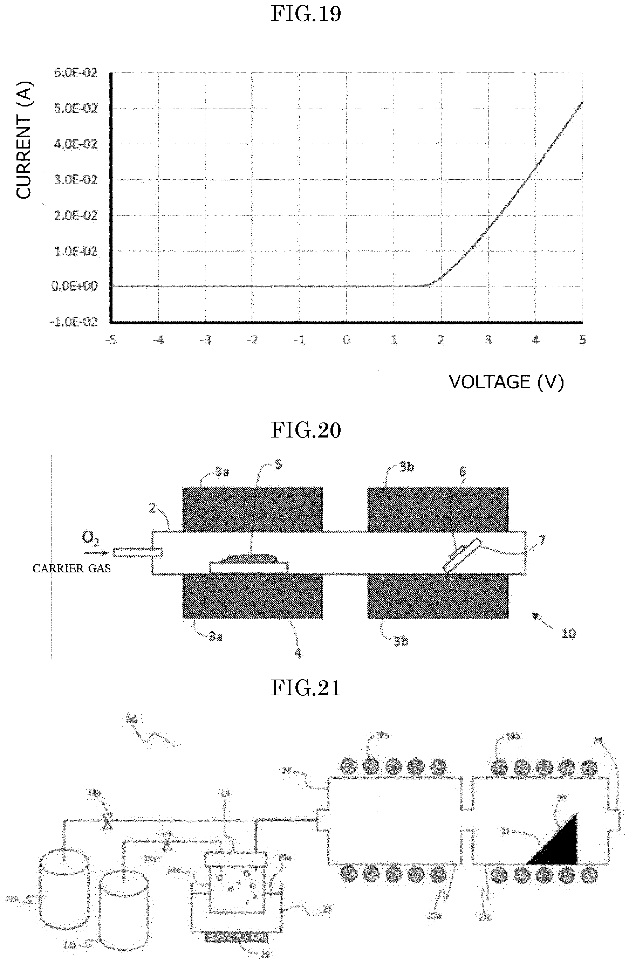

The deposition method of the p-type oxide semiconductor film according to one or more embodiments of the disclosure includes, for example, using a two-zone system deposition apparatus illustrated in Fig.21, atomizing a raw material solution including the precursor of the metal oxide gas or forming droplet from the raw material solution (atomizing and forming droplet step), evaporating and optionally sublimating the obtained mist or droplets (evaporation step), then using the obtained metal oxide gas, conducting a crystal growth on the base having the corundum structure (crystal growth step). Here, the base and the crystal growth step may be the same as the base and the crystal growth step in the crystal growth step in the forming method of the p-type oxide semiconductor film using the solid-state material of the metal oxide gas as described above. By depositing the p-type oxide semiconductor film in this way, unlike a conventional mist-CVD method and the like, it is possible to form the p-type oxide semiconductor film more preferably, and it is possible to obtain the p-type oxide semiconductor film having enhanced semiconductor properties and enhanced surface smoothness.

### (Atomizing and forming droplet step)

At an atomizing and forming droplet step, the raw material solution is atomized or turned into droplets. A method of atomizing or forming droplets from the raw material solution is not particularly limited, as long as the raw material solution is able to atomized or turned into droplets, and may be a known method. According to one or more embodiments of the disclosure, a method of atomizing or forming atomized droplets using ultrasonic vibration is preferable.

Atomized droplets including mist obtained by using ultrasonic vibration have an initial velocity that is zero and float in the space. Since atomized droplets floating in the space are carriable as a gas, the atomized droplets floating in the space are preferable to avoid damage caused by the collision energy without being blown like a spray. A size of the atomized droplets is not limited to a particular size, and may be a few millimeters, however, the size of atomized droplets is preferably equal to or less than 50 µm. The size of droplets is further preferably in a range of from 100 nm to 10 µm.

### (Raw material solution)

Raw material solution is not particularly limited as long as the raw material solution contains a precursor of the metal oxide gas, and can be atomized or turned into droplets. The raw material solution may contain an inorganic material or an organic material. According to one or more embodiments of the disclosure, it is preferable that the raw material solution contains a metal that is contained in the p-type oxide semiconductor film. It is also preferable that the raw material solution contains a compound of the metal that is contained in the p-type oxide semiconductor film. According to one or more embodiments of the disclosure, the raw material solution including the metal contained in the p-type oxide semiconductor film in the form of complex or salt, and dissolved or dispersed in organic solvents or water may be preferably used. Examples of the form of the complex include acetylacetonate complexes, carbonyl complexes, ammine complexes, hydride complexes. Also, examples of the form of salt include organic metal salts (e.g., metal acetate, metal oxalate, metal citrate, etc.), metal sulfide salt, metal nitrate salt, metal phosphate salt, metal halide salt (e.g., metal chloride salt, metal bromide salt, metal iodide salt, etc.).

Further, raw material solution may contain a hydrohalic acid and/or an oxidant as an additive. Examples of the hydrohalic acid include hydrobromic acid, hydrochloric acid and hydroiodic acid. Among all, hydrobromic acid or hydroiodic acid may be preferable for a reason to obtain a film of better quality. Examples of the oxidant include peroxide such as hydrogen peroxide (H₂O₂), sodium peroxide (Na₂O₂), barium peroxide (BaO₂), benzoyl peroxide (C₆H₅CO)₂O₂, and organic peroxide such as hypochlorous acid (HClO), perchloric acid, nitric acid, ozone water, peracetic acid and nitrobenzene.

The raw material solution may contain a dopant. By adding a dopant into the raw material solution, it is possible to preferably perform doping. The dopant is not particularly limited unless it deviates from an object of the disclosure. Examples of the dopant include n-type dopants. The n-type dopants may include tin, germanium, silicon, titanium, zirconium, vanadium or niobium. Also, examples of the dopant include p-type dopants. The dopant concentration in general may be approximately in a range of from 1×10 ¹⁶/cm³ to 1×10²²/cm³. The dopant concentration may be at a lower concentration of, for example, approximately equal to or less than 1×10 ¹⁷/cm³. According to one or more embodiments of the disclosure, the dopant may be contained at a high concentration of, for example, approximately equal to or more than 1×10²⁰/cm³. According to one or more embodiments of the disclosure, it is preferable that the dopant is contained in a carrier concentration of equal to or more than 1×10¹⁷/cm³.

A solvent of raw material solution is not particularly limited, and may be an inorganic solvent such as water, an organic solvent such as alcohol. Also, the solvent may be a mixed solvent of the inorganic solvent and the organic solvent. According to one or more embodiments of the disclosure, it is preferable that the solvent contains water, and it is more preferable that the solvent is water or a mixed solvent of water and alcohol.

### (Evaporation process)

In the evaporation step, the metal oxide gas is obtained by evaporating and optionally oxidizing a liquid substance (for example, mist) of the precursor of the metal oxide gas. The metal oxide gas may be the same gas as the metal oxide gas in the sublimation step. The evaporation method may be, for example, a heating method. The heating temperature in the evaporation method may be the same as the heating temperature in the sublimation means. According to one or more embodiments of the disclosure, it is preferable that the metal oxide gas obtained by evaporation is carried to the base by a carrier gas. A type of the carrier gas is not particularly limited unless it deviates from an object of the disclosure, and for example, oxygen, ozone, an inert gas such as nitrogen, or argon, or a reducing gas such as a hydrogen gas or a forming gas. In particular, an oxygen gas and/or an ozone gas is preferable. According to one or more embodiments of the disclosure, by using oxygen gas and/or ozone gas as the carrier gas, the precursor of the metal oxide gas can be more preferably oxidized. Further, the carrier gas may contain one or two or more gasses. Also, a diluted gas (e.g., 10-fold diluted carrier gas) and the like may be further used as a second carrier gas. The carrier gas may be supplied from one or more locations. While a flow rate of the carrier gas is not particularly limited, but may be preferably in a range of from 0.01 L/min to 20 L/min and more preferably in a range of from 1 L/min to 10 L/min.

The p-type oxide semiconductor film obtained by above-mentioned method is able to preferably used as a p-type semiconductor layer by using a known method. According to one or more embodiments, it is preferable to form the p-type oxide semiconductor film by using sublimate of a solid substance of the metal oxide gas (for example, powder) as the metal oxide gas, for a reason that the p-type oxide semiconductor with excellent surface smoothness that is for example equal to or less than 5 nm. According to one or more embodiments of the disclosure, the p-type semiconductor may be provided directly on the base. The p-type semiconductor layer may be provided via another layer on the base. Examples of the another layer includes a semiconductor layer (n-type semiconductor layer, n--type semiconductor layer, n+-type semiconductor layer, for example) that is different from the p-type semiconductor layer, an insulating layer including semi-insulating layer and a buffer layer. Examples of the semiconductor layer and the insulating layer include a semiconductor layer including the metal of Group 13 of the periodic table and an insulating layer including the metal of Group 13 of the periodic table. Preferable examples of the buffer layer may include a semiconductor layer with a corundum structure, an insulating layer with a corundum structures, and an electrically conductive layer with a corundum structure. Examples of the semiconductor layer include α-Fe₂O₃, α-Ga₂O₃, or α-Al₂O₃. A method of forming the buffer layer on the base is not particularly limited and may be by use of a method similarly to a method of forming the p-type oxide semiconductor as mentioned above.

According to one or more embodiments of the disclosure, the n-type oxide semiconductor layer is preferably formed before or after the formation of the p-type oxide semiconductor layer. More specifically, the above-mentioned method of manufacturing the semiconductor device may preferably include at least forming a p-type semiconductor and forming an n-type semiconductor layer. A method of forming the n-type semiconductor layer is not particularly limited and may be a known method. According to one or more embodiments of the disclosure, the n-type semiconductor layer is preferably formed by mist CVD method. The n-type semiconductor layer preferably contains an oxide semiconductor as a major component. The oxide semiconductor contained in the n-type semiconductor layer may preferably contain a metal of Group 13 (Al, Ga, In, Tl, for example). According to one or more embodiments of the disclosure, the n-type semiconductor layer may preferably contain a crystalline oxide semiconductor as a major component, may further preferably contain as a major component a crystalline oxide semiconductor containing Ga, and may most preferably contain as a major component a crystalline oxide semiconductor with a corundum structure containing Ga. Also, according to one or more embodiments of the disclosure, a difference in lattice constants between the oxide semiconductor contained as a major component in the n-type semiconductor layer and the p-type oxide semiconductor may be preferably 1.0% or less, to realize an enhanced p-n junction, and the difference in lattice constants may be further preferably 0.3% or less. The term "difference in lattice constant" herein is defined as a numerical value (%) obtained by subtracting a lattice constant of the p-type oxide semiconductor from a lattice constant of the oxide semiconductor contained as a major component in the n-type semiconductor layer to obtain a value of difference, and dividing the value of the difference by the lattice constant of the p-type oxide semiconductor to obtain an absolute value, and then, multiplying the absolute value by 100. Examples when the difference in lattice constants of a p-type oxide semiconductor layer and an n-type oxide semiconductor layer is 1.0% or less include a case in which the p-type oxide semiconductor has a corundum structure and the oxide semiconductor as the major component of the n-type semiconductor also has a corundum structure. More preferable examples include a case in which the p-type oxide semiconductor is preferably a single crystal of Ir₂O₃ or a mixed crystal of Ir₂O₃ and the oxide semiconductor contained as the major component in the n-type semiconductor layer is preferably a single crystal of Ga₂O₃ or a mixed crystal Ga₂O₃. The term "major component" herein means that the oxide semiconductor is preferably contained in the n-type semiconductor layer at an atomic ratio of equal to or more than 50 % to all the component in the n-type semiconductor layer. The oxide semiconductor may be preferably contained in the n-type semiconductor layer at an atomic ratio of equal to or more than 70 % to all the component in the n-type semiconductor layer, and may be more preferably equal to or more than 90 %. The oxide semiconductor may be contained in the n-type semiconductor layer at an atomic ratio of 100 % to all the component in the n-type semiconductor layer. According to one or more embodiments of the disclosure, the p-type oxide semiconductor may be a single crystal or may be a polycrystal.

The p-type oxide semiconductor film obtained by the above-mentioned preferable method is industrially useful, also has enhanced electrical properties. More specifically, a carrier mobility of the p-type oxide semiconductor film is usually equal to or more than 1.0 cm²/V·s. The carrier mobility herein means a carrier mobility measured by Hall-effect measurement. According to one or more embodiments in the disclosure, the carrier mobility of the p-type oxide semiconductor film is preferably equal to or more than 3.0 cm ²/V·s. Also, a carrier concentration of the p-type oxide semiconductor film may be preferably equal to or more than 8.0×10²⁰/cm³. The carrier concentration herein means a carrier concentration of the semiconductor film measured by Hall effect measurement. Although a lower limit of the carrier concentration is not particularly limited, the lower limit of the carrier concentration may be preferably equal to or more than approximately 1.0×10¹⁵/cm³, and may be preferably equal to or more than approximately 1.0×10¹⁷/cm³. According to one or more embodiments in the disclosure, it is possible to easily control the carrier concentration in a range of from 1.0×10¹⁶/cm³ to 1.0×10²⁰/cm³ by adjusting a type and amount of a dopant or by adjusting a material of a mixed crystal and concentration of the material in the mixed crystal.

The p-type oxide semiconductor film obtained as described above is able to be used for a semiconductor device as a p-type semiconductor layer. The p-type oxide semiconductor film is particularly useful for a power device. By applying the p-type oxide semiconductor film for a semiconductor device, roughness scattering may be suppressed, and the channel mobility of the semiconductor device may be enhanced. Semiconductor devices may be categorized into lateral devices and vertical devices. In a lateral device, a first electrode and a second electrode may be formed on one side of a semiconductor layer. In a vertical device, a first electrode may be formed on a first side of a semiconductor layer and a second electrode may be formed on a second side of the semiconductor layer. The first side is positioned opposite to the second side of the semiconductor layer. According to an embodiment, the p-type oxide semiconductor may be used for the lateral devices and used for vertical devices. According to an embodiment, the p-type oxide semiconductor may be preferably used for vertical devices. Examples of the semiconductor device include Schottky barrier diode (SBDs), metal semiconductor field-effect transistors (MESFETs), high- electron-mobility transistors (HEMTs), metal oxide semiconductor field-effect transistors (MOSFETs), static induction transistors (SIT), junction field-effect transistors (JFETs), insulated gate bipolar transistors (IGBTs), and light emitting diodes.

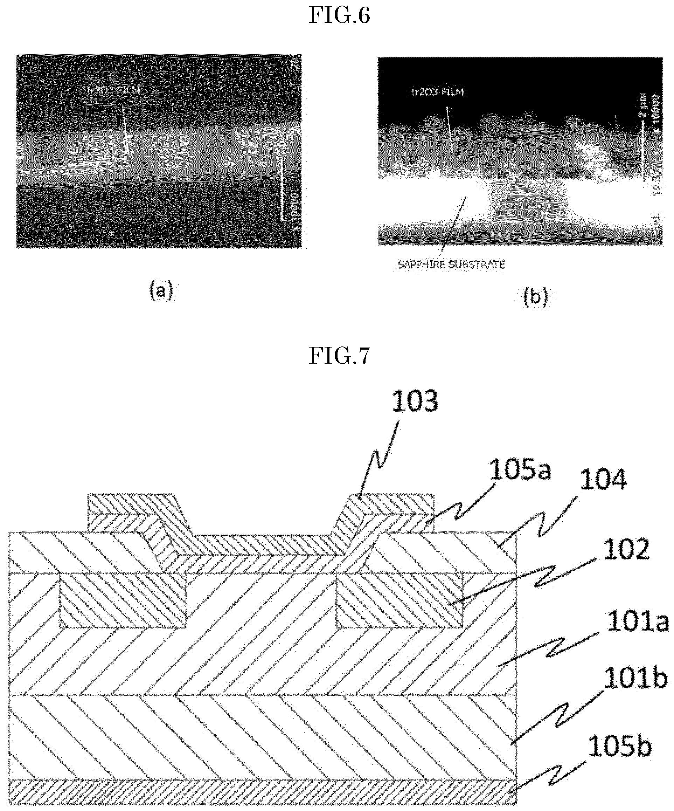

Fig.7 to Fig.9 illustrates examples of using the p-type oxide semiconductor of the disclosure as a p-type semiconductor layer. According to one or more embodiments of the disclosure, an n-type semiconductor may be a semiconductor containing the same major component as a major component of the p-type semiconductor layer and an n-type dopant. The n-type semiconductor may be a semiconductor containing a major component that is different from the major component of the p-type oxide semiconductor. Also, the n-type semiconductor may be used as an n⁻-type semiconductor layer or an n⁺-type semiconductor layer by using known method such as adjusting a concentration of n-type dopant in the n-type oxide semiconductor.

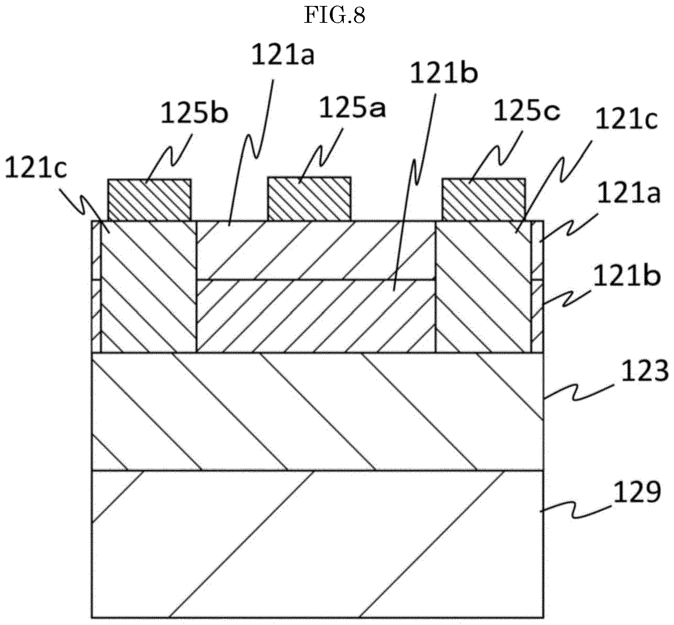

Fig.7 illustrates an embodiment of a Schottky barrier diode (SBD) according to the disclosure including an n--type semiconductor layer 101a, an n+-type semiconductor layer 101b, a p-type semiconductor layer 102, a metal layer 103, an insulating layer 104, a Schottky electrode 105a, and an Ohmic electrode 105b. The metal layer 103 is made of a metal such as Al and covers the Schottky electrode 105a. Fig.8 illustrates an embodiment of a high electron-mobility transistor (HEMT) including an n-type semiconductor layer with wide band gap 121a, an n-type semiconductor layer with narrow band gap 121b, an n+-type semiconductor layer 121c, a p-type semiconductor layer 123, a gate electrode 125a, a source electrode 125b, a drain electrode 125c, and a substrate 129.

A material of the Schottky electrode and the Ohmic electrode may be a known material. Examples of the electrode material include Al, Mo, Co, Zr, Sn, Nb, Fe, Cr, Ta, Ti, Au, Pt, V, Mn, Ni, Cu, Hf, W, Ir, Zn, In, Pd, Nd, Ag and/or alloys thereof, metal oxide conductive films such as tin oxide, zinc oxide, rhenium oxide, indium oxide, indium tin oxide (ITO), and indium zinc oxide (IZO), organic conductive compounds such as polyaniline, polythiophene, and polypyrrole, and a mixture or a multilayer structure of these materials.

Formation of the Schottky electrode and the Ohmic electrode can be performed by, for example, a known method such as a vacuum evaporation method or a sputtering method. For more details, if a Schottky electrode is formed by using two metals including a first metal and a second metal, a layer of the first metal may be arranged on a layer of the second metal, and patterning may be conducted on the layers of the first metal and the second metal by using a photolithography method.

Examples of the material for the insulating layer include GaO, AlGaO, InAlGaO, AlInZnGaO4, A1N, Hf₂O₃, SiN, SiON, Al₂O₃, MgO, GdO, SiO₂, and/or Si₃N₄. According to an embodiment, the insulating layer may preferably contain a corundum structure. The insulating layer may be formed by a known method such as sputtering, vacuum evaporation or CVD method.

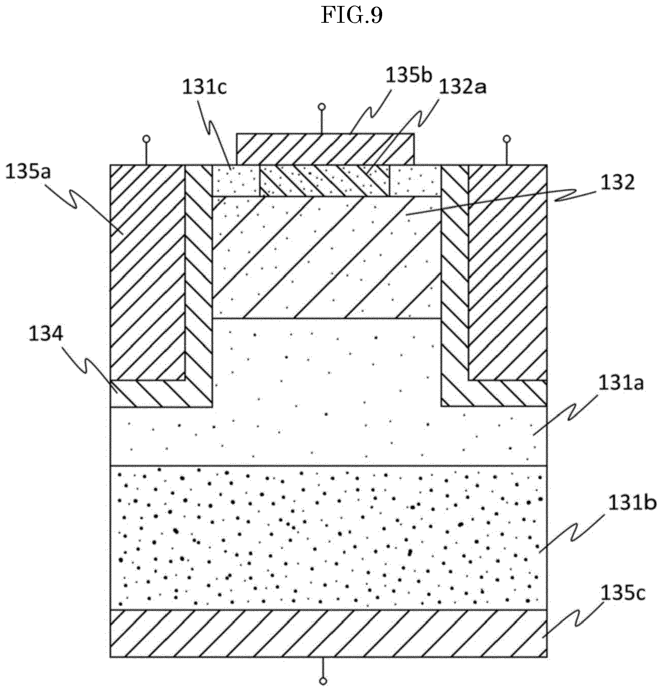

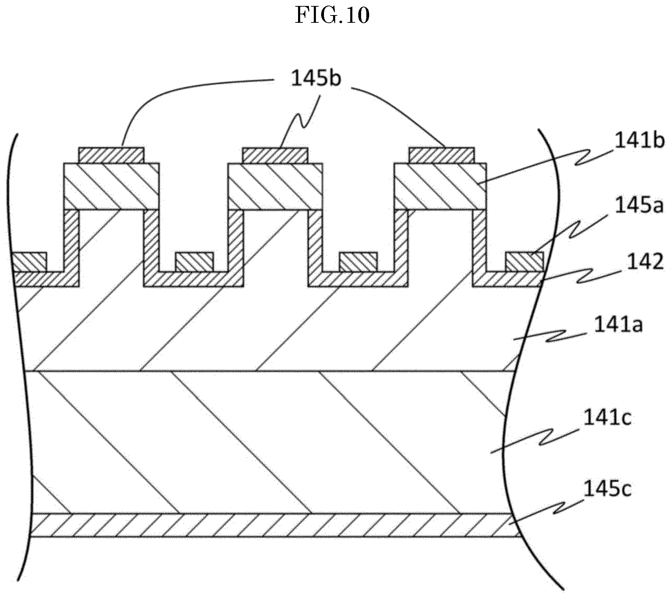

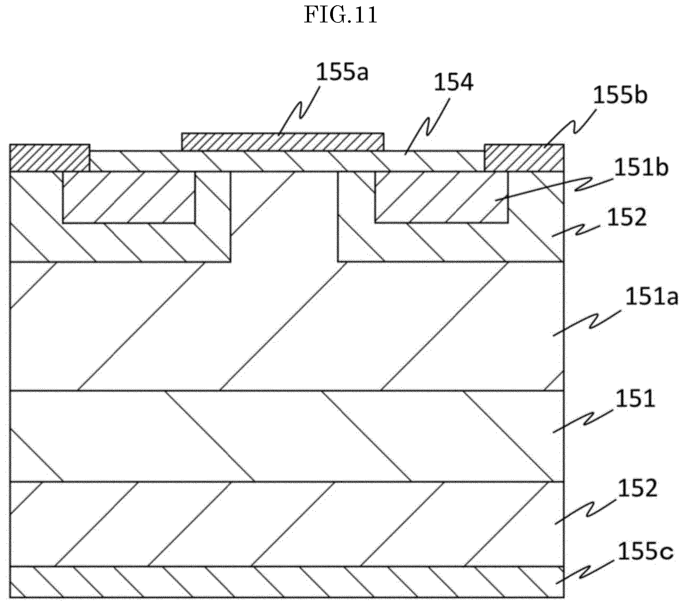

Fig.9 illustrates an embodiment of a metal oxide semiconductor field-effect transistor (MOSFET) according to the disclosure including an n--type semiconductor layer 131a, a first n+-type semiconductor layer 131b, a second n+-type semiconductor layer 131c, a p-type semiconductor layer 132, a p+-type semiconductor layer 132a, a gate insulating film 134, a gate electrode 135a, a source electrode 135b, and a drain electrode 135c. The p+-type semiconductor layer 132a may be a p-type semiconductor layer and may be the same as the p-type semiconductor layer 132. Fig.10 illustrates an embodiment of a junction field-effect transistor (JFET) according to the disclosure including an n--type semiconductor layer 141a, a first n+-type semiconductor layer 141b, a second n+-type semiconductor layer 141c, a p-type semiconductor layer 142, a gate electrode 145a, a source electrode 145b, and a drain electrode 145c. Fig.11 illustrate an embodiment of an insulated gate bipolar transistor (IGBT) according to the disclosure including an n-type semiconductor layer 151, an n--type semiconductor layer 151a, an n+-type semiconductor layer 151b, a p-type semiconductor layer 152, a gate insulating film 154, a gate electrode 155a, an emitter electrode 155b, and a collector electrode 155c.

### (LED)

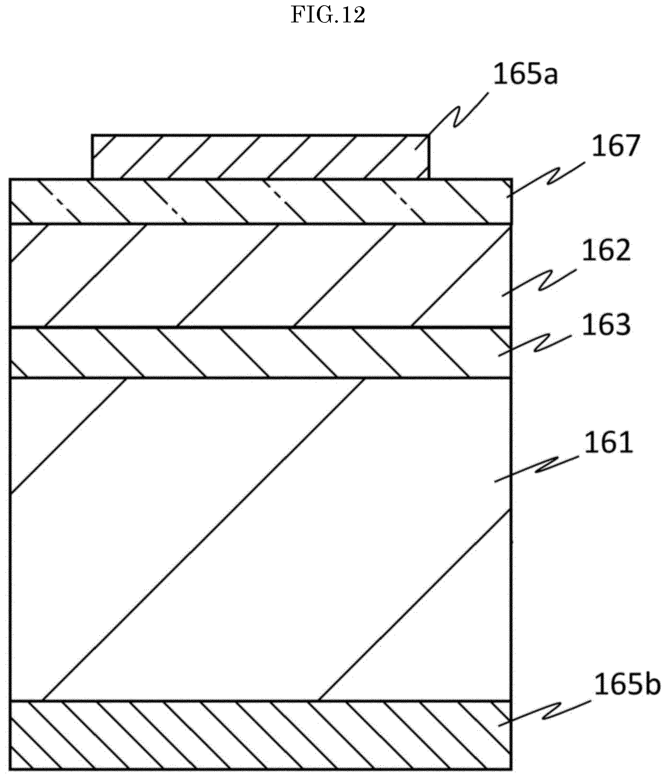

Fig.12 illustrates an embodiment of a light emitting diode (LED) according to the disclosure. A semiconductor light emitting element illustrated in Fig.12 includes an n-type semiconductor layer 161 on a second electrode 165b, and a light emitting layer 163 is positioned on the n-type semiconductor layer 161. Also, a p-type semiconductor layer 162 is positioned on the light emitting layer 163. A light-transmitting electrode 167, that permeates the light generated in the light emitting layer 163, is provided on the p-type semiconductor layer 162. A first electrode is positioned on the light-transmitting electrode 167. A light emitting material used for the light emitting layer may be a known material. The light emitting element illustrated in Fig.12 may be covered with a protective layer except for the electrode portion.

Examples of the material of the light-transmitting electrode include oxide conductive material containing indium or titanium. Regarding the material of the light-transmitting electrode, in detail, the material may be In₂O₃, ZnO, SnO₂, Ga₂O₃, TiO₂, a mixed crystal thereof. The material may contain a dopant. By providing those materials using known method such as sputtering, the light-transmitting electrode would be formed. Also, annealing may be carried out after forming the light-transmitting electrode, in order to make the electrode more transparent.

According to the light emitting element illustrated in Fig.8, the light-emitting layer 163 is configured to emit light by applying a current to the p-type semiconductor layer 162, the light emitting layer 163, and the n-type semiconductor layer, through the first electrode 165a as a positive electrode and the second electrode as a negative electrode.

Examples of the material of the first electrode 165a and the second electrode 165b include Al, Mo, Co, Zr, Sn, Nb, Fe, Cr, Ta, Ti, Au, Pt, V, Mn, Ni, Cu, Hf, W, Ir, Zn, Pd, Nd, Ag and/or alloys thereof, metal oxide conductive films such as tin oxide, zinc oxide, indium oxide, indium tin oxide (ITO), and indium zinc oxide (IZO), organic conductive compounds such as polyaniline, polythiophene, and polypyrrole, and mixtures of these materials. A forming method of the first and the second electrode is not particularly limited. Examples of the forming method of the first and the second electrode include wet methods such as printing method, spray method, coating method, physical methods such as vacuum deposition method, sputtering method, ion planting method, chemical methods such as CVD method, plasma CVD method. The forming method may be selected from above mentioned methods in consideration of a suitability for the material of the first electrode and the second electrode.

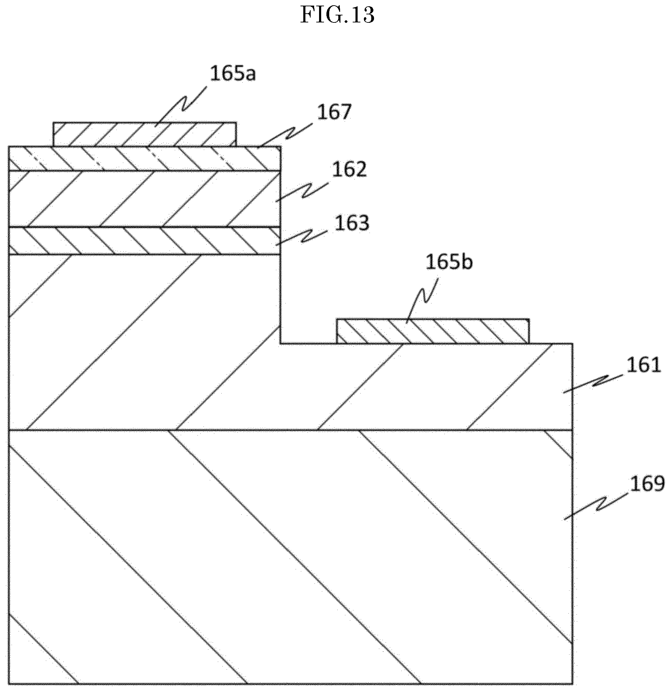

Fig.13 illustrates another embodiment of a light emitting diode (LED). In the LED illustrated in Fig.9, an n-type semiconductor layer 161 is arranged on the substrate 169, and the second electrode 165b is arranged on a part of the exposed surface of the n-type semiconductor layer 161, in which the exposed surface is formed by cutting out a part of a p-type semiconductor layer 162, light-emitting layer 163 and the n-type semiconductor layer 161.

### (HBT)

Fig.13 illustrates an embodiment of a heterojunction bipolar transistor (HBT) according to the disclosure. The HBT illustrated in Fig.13 is able to have either an npn structure or a pnp structure. Hereinafter, an embodiment with the npn structure according to the disclosure will be described in detail, however, an embodiment with the pnp structure is the same as the embodiment with the npn structure in the point that the p-type layer with the of npn structure is replaceable by an n-type layer, and the n-type layer of the npn structure is replaceable by the p-type layer. The substrate 60 may be a semi-insulating base and may have a high resistivity (for example, more than 10⁵Ωcm). The substrate 60 may have an n-type conductivity.

A collector layer 42 is formed above the substrate 60. The collector layer 42 may have a thickness of, for example, 200nm to 100µm and may preferably have a thickness of 400nm to 20µm. The collector layer 42 may contain as a major component a corundum-structured n-type oxide semiconductor. According to one or more embodiments of the disclosure, the n-type oxide semiconductor contained in the collector layer 42 may preferably contain as a major component an oxide semiconductor containing a metal of Group 2 of the periodic table (Be, Mg, Ca, Sr, Ba, for example), a metal of Group 9 of the periodic table (Co, Rh, Ir, for example), or a metal of Group 13 of the periodic table (Al, Ga, In, Tl, for example). According to one or more embodiments of the disclosure, the n-type oxide semiconductor contained in the collector layer may further preferably contain at least one metal selected from among aluminum, indium and gallium. According to the disclosure, the n-type oxide semiconductor contained in the collector layer may be most preferably a gallium oxide or a mixed crystal of gallium oxide. The term "major component" herein means the same as the meaning of "major component" as mentioned above. Also, according to one or more embodiments of the disclosure, a dopant contained in the n-type oxide semiconductor (Sn, Ge, Si, or Ti, for example) normally has a concentration that is approximately 1×10¹⁶/cm³ to 1 × 10²²/cm³. According to one or more embodiments of the disclosure, the n-type oxide semiconductor may be an n⁻-type semiconductor by adjusting the concentration of the n-type dopant in the n-type oxide semiconductor to be approximately 1×10¹⁷/cm³ or less. Also, the n-type oxide semiconductor may be an n⁺-type semiconductor by adjusting the concentration of the n-type dopant in the n-type oxide semiconductor to be approximately 1×10²⁰/cm³ or more.

According to an embodiment of the disclosure, especially when the substrate 60 is semi-insulating, a sub-collector layer 40 may be provided between the collector layer 42 and the substrate 60. The sub-collector layer 40 may preferably contain as a major component a corundum-structured n⁺-type oxide semiconductor. According to an embodiment of the disclosure, the n⁺-type oxide semiconductor contained in the sub-collector layer 40 may preferably contain as a major component an oxide semiconductor containing a metal of Group 13 of the periodic table (Al, Ga, In, Tl, for example). According to one or more embodiments of the disclosure, the n⁺-type oxide semiconductor contained in the sub-collector layer 40 may further preferably contains at least one metal selected from among aluminum, indium and gallium. According to the disclosure, the n⁺-type oxide semiconductor contained in the sub-collector layer 40 may be most preferably a gallium oxide or a mixed crystal of gallium oxide. The term "major component" herein means as same as the above mentioned "major component". A thickness of the sub-collector layer 40 may be approximately in a range of from 0.1 to 100µm. A collector electrode 52 is formed on a surface of the sub-collector layer 40. The sub-collector layer 40 aims to enhance the performance of the ohmic collector electrode 52. The sub-collector layer 40 may be omitted if the substrate 60 is electrically conductive.

A base layer 44 is formed on the collector layer 42. Normally, the base layer 44 is not particularly limited as long as the base layer 44 contains as a major component the p-type oxide semiconductor according to an embodiment. A thickness of the base layer 44 is not particularly limited and may be preferably in a range of from 10nm to 10µm, and may be further preferably in a range of from 10nm to 1µm. According to one or more embodiments of the disclosure, it is preferable that the composition of the base layer 44 is gradually changed from a portion in contact with the collector layer to a portion adjacent to the top of the base layer 44. According to another preferably embodiment of the disclosure, a super lattice may be arranged to be deposited on the base layer 44.

An emitter layer 46 is formed on the base layer 44. The emitter layer 46 may preferably contain as a major component a corundum-structured n-type oxide semiconductor. According to one or more embodiments of the disclosure, the n-type oxide semiconductor contained in the emitter layer 46 may preferably contain as a major component an oxide semiconductor containing a metal of Group 13 of the periodic table (Al, Ga, In, Tl, for example). According to one or more embodiments of the disclosure, the n-type oxide semiconductor contained in the emitter layer may further preferably contain at least one metal selected from among aluminum, indium and gallium. According to the disclosure, the n-type oxide semiconductor contained in the emitter layer 46 may be most preferably a gallium oxide or a mixed crystal of gallium oxide. The term "major component" herein means the same as the meaning of "major component" as mentioned above. A thickness of the emitter layer is not particularly limited and may be in a range of from 10nm to 100µm. The emitter layer 46 normally has a wider band gap than the base layer 44. According to a preferable embodiment, the composition of the emitter layer 46 may be gradually changed from the interface with the base layer 44 to the top of the emitter layer 46.

According to one or more embodiments of the disclosure, a cap layer 48 may be preferably formed on the emitter layer 46. The cap layer 48 may be a layer of n⁺-type oxide semiconductor and may be preferably a layer of n⁺-type oxide semiconductor containing at least one metal selected from among aluminum, indium and gallium. According to one or more embodiments of the disclosure, the cap layer 48 may be further preferably a layer of n⁺-doped gallium oxide or a layer of a mixed crystal of n⁺-doped gallium oxide. The thickness of the cap layer 48 is not particularly limited and may be in a range of from 10nm to 100µm. The base layer 44 can be exposed, for example, by etching the cap layer 48 emitter layer 46. Also, when an upward collector electrode is provided, for example, it is possible to expose the sub-collector layer 40 by etching further layers to make a deeper through-hole.

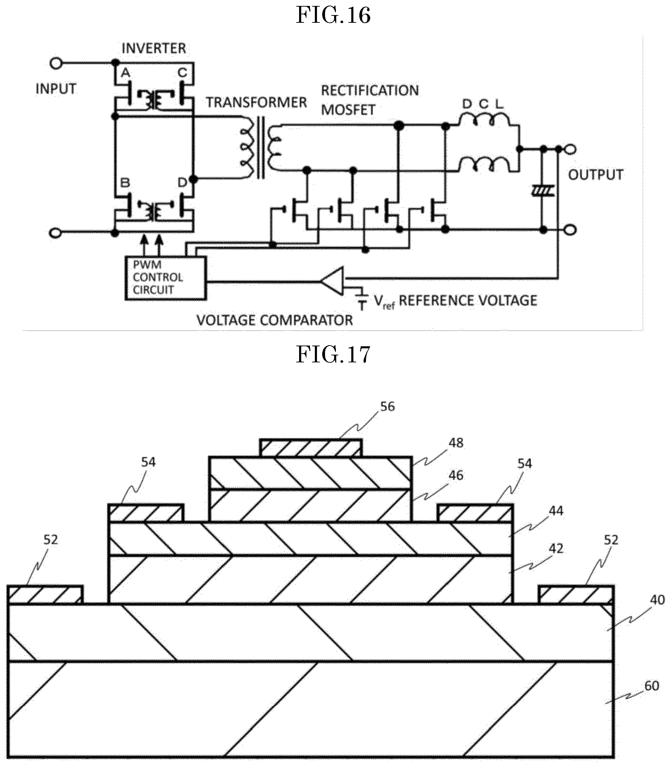

Each of the collector electrode 52, a base electrode 54 and an emitter electrode 56 may be preferably an ohmic metal electrode. The emitter electrode 56 is formed on the cap layer 48 to be deposited. The base electrode 54 is formed, for example, on an exposed surface of the base layer 44 exposed by etching. The collector electrode 52 is formed on the sub-collector layer 40 as mentioned above. According to another embodiment of the disclosure, when the substrate is an n-type semiconductor, the collector electrode (not shown in Fig.17) is provided on a back side that is an opposite side of the side with the device structure of the substrate.

The material of each electrode is not particularly limited and a known material may be used for each electrode. According to one or more embodiments of the disclosure, examples of suitable components for each electrode include a known material for an ohmic electrode (that is Ni, Al, Ti, Pt, Au and laminate thereof, for example). A thickness of each electrode is not particularly limited and may be approximately 10 to 100µm. A deposition of each electrode may be conducted by electron beam evaporation, thermal evaporation, sputtering or deposition methods. According to one or more embodiments of the disclosure, annealing may be conducted after the deposition of each electrode, in order to achieve an ohmic contact. A temperature of annealing is not particularly limited and may be approximately in a range of from 300°C to 1000°C.
It should be noted that an HBT with the pnp structure is obtained, by replacing the p-type layer of the HBT with the pnp structure by the n-type layer of the HBT with the npn structure, and also obtainable by replacing the n-type layer of the HBT with the pnp structure by the p-type layer of the HBT with the npn structure.

According to one or more embodiments of the disclosure, it is preferable to use the p-type oxide semiconductor film in semiconductor devices of (1) to (3) as described below.

### (1) Semiconductor device including p-type channels

A semiconductor device (1) includes at least a gate electrode and a channel layer where a channel is formed, in which the channel layer is provided directly or via another layer on a side wall of the gate electrode, and a part or all of the channel layer includes a p-type oxide semiconductor as major component. The channel layer is not particularly limited as long as the channel is formed in the channel layer, and may be a part of a semiconductor layer or may be a semiconductor layer. The channel layer may be formed over other semiconductor layers. By using the p-type oxide semiconductor film as a p-type semiconductor layer, without using ion implantation and the like, a low-loss and high voltage n-type semiconductor that has dielectric breakdown field strength much higher than SiC may be used for semiconductor devices without impairing semiconductor properties.

It is preferable that the semiconductor device (1) further includes a built-in SBD. Such a built-in SBD enables to reduce on-voltage and to facilitate a flow of a freewheel current, and thus, it is possible to obtain industrially advantageously more enhanced semiconductor characteristics.

### (2) Semiconductor device including a p-well layer

A Semiconductor device (2) is a semiconductor device includes at least an n-type semiconductor layer and a p+-type semiconductor layer, and the n-type semiconductor layer includes a crystalline oxide semiconductor as major component containing a metal of Group 13 of the periodic table, p+-type semiconductor layer contains the p-type oxide semiconductor film as a major component. According to one or more embodiments of the disclosure, the p-type oxide semiconductor film is able to be preferably used as a p-well layer.

### (3) Semiconductor device including an electric field shield layer

A semiconductor device (3) includes an n-type semiconductor layer including a crystalline oxide semiconductor with a corundum structure, an electric field shield layer and a gate electrode that are formed directly or via another layer on the n-type semiconductor layer, in which the electric field shield layer contains a p-type oxide semiconductor and embedded in the n-type semiconductor in that deeper than the gate electrode. By providing the electric field shield layer in this way, it is possible to reduce reverse leakage current.

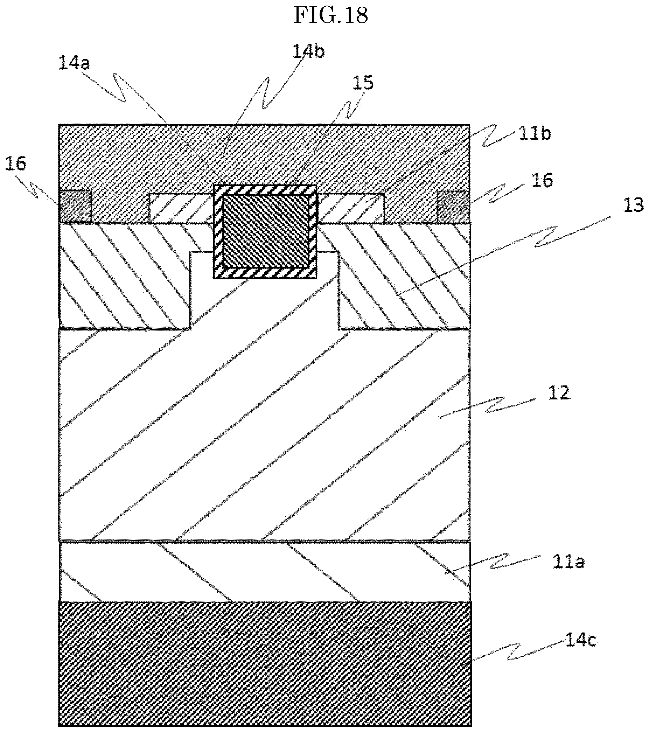

Fig. 18 illustrates the most preferable embodiment of a semiconductor device that includes the above-mentioned (1) to (3). The semiconductor device illustrated in Fig.18, includes a first n+-type semiconductor layer 11a, an n--type semiconductor layer 12, a p-type semiconductor layer 13, a second n+-type semiconductor layer 11b, a p+-type semiconductor layer 16, a gate electrode 14a, a gate insulating film 15, a Schottky electrode 14b and a drain electrode 14c. In an on-state of the semiconductor device of Fig.18, when a voltage is applied between the source electrode 14b and the drain electrode 14c to give a positive charge to the gate electrode with respect to the source electrode 14b, a channel is formed at an interface between the p-type semiconductor layer 13 and the gate insulating film 14, and the semiconductor device turns on. In an off-state, by adjusting a voltage of the gate electrode to be 0V, the channel is no longer formed and the semiconductor device turns off. Further, the semiconductor device illustrated in Fig.18, the p-type semiconductor layer 13 is embedded in the n--type semiconductor layer in that deeper than the gate electrode 14a. Such a configuration enables to reduce reverse leakage current and to enhance withstand voltage.

A method of forming each layer included in the semiconductor device of Fig.18 is not particularly limited unless it deviates from an object of the disclosure, and may be a known method. Examples of the method of forming the each layer include a method in which, after a film is formed using a vacuum evaporation method, a CVD method, a sputtering method or other various coating techniques, patterning is conducted by photolithography. Also, examples of the method of forming the each layer include a method in which patterning is conducted directly by using a printing technique and the like.
In the semiconductor device of Fig.18, the second n +-type semiconductor layer 11b and the p+-type semiconductor layer 16 is continuously provided through the source electrode 14b. According to one or more embodiments of the disclosure, the second n+-type semiconductor layer 11b and the p+-type semiconductor layer 16 may be continuously provided without going through the source electrode 14b. Although not illustrated in Fig.18, when the second n+-type semiconductor layer 11b and the p +-type semiconductor layer 16 is directly connected, by providing the p+-type semiconductor layer 16 to be wider than the n+-type semiconductor layer 11b, a hole escape would be improved. Further, when providing the second n+-type semiconductor layer to be wider than the p+-type semiconductor layer, on-resistance would be reduced.

The semiconductor device of the disclosure is particularly useful for a power device. Examples of the semiconductor device includes, a diode (for example, SBD) or a transistor (for example, MOSFET or JFET). According to one or more embodiments of the disclosure, SBD, MOSFET, IGBT or JFET is more preferable, MOSFET or JFET is the most preferable. Further, it is preferable that the semiconductor device includes a silicon-on-insulator (SOI) structure including a silicon substrate and an insulating layer buried on the silicon substrate, for a reason that the semiconductor device would work at a higher temperature.

In addition, the semiconductor device according to the disclosure may be used as a power module, an inverter, and/or a converter in combination with a known structure. Also, a semiconductor device according to the disclosure may be used in a semiconductor system including a power source, to which the semiconductor device may be electrically connected by a known structure and/or method. The semiconductor device may be electrically connected to a wiring pattern in the semiconductor system.

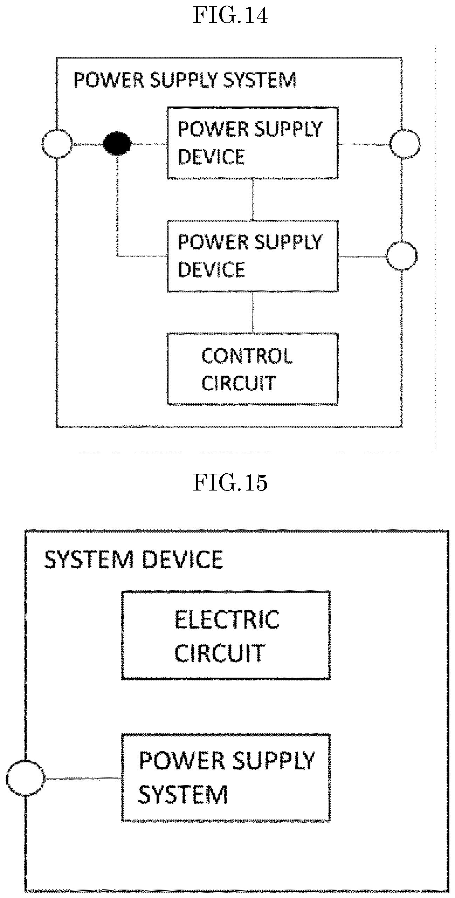

Fig.14 is a schematic view of a circuit diagram illustrating a power source system according to one or more embodiments of the disclosure. Fig.14 illustrates a schematic view of the power source system using two or more power source devices and a control circuit. The power source system is, as illustrated in Fig.15, used for a system device in combination with a circuit diagram. Also, Fig.16 illustrates a power source circuit of a power source device, including a power circuit and a control circuit. A DC voltage is switched at high frequencies by an inverter (configured with MOSFET A to D) to be converted to AC, followed by insulation and transformation by a transformer. The voltage is then rectified by a rectification MOSFET and then smoothed by a DCL (smoothing coils L1 and L2) and a capacitor to output a direct current voltage. At this point, the output voltage is compared with a reference voltage by a voltage comparator to control the inverter and the rectification MOSFETs by a PWM control circuit to have a desired output voltage.

### [Examples]

### (Example 1)

### 1. Deposition equipment

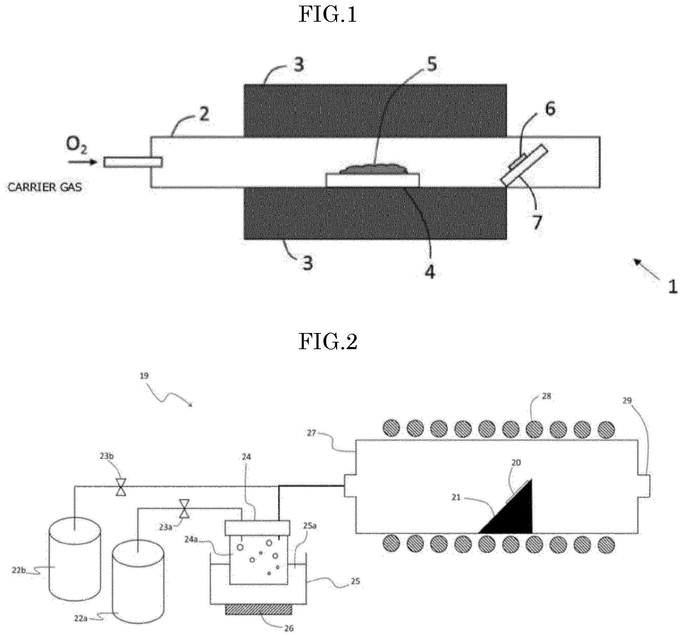

With reference to Fig.1, a deposition apparatus used in this embodiment is described. The deposition apparatus 1 illustrated in Fig.1 includes a quartz cylinder 2 that is connected to a carrier gas supply source, and a quartz raw material mount 4 that is provided in the quartz cylinder 2. The raw material 5 is placed on the raw material mount 4. A cylindrical heater is provided on an outer cylinder of the quartz cylinder 2 around the raw material installation mount and is configured to be able to heat the raw material 5. Further, a quartz substrate base is provided as a susceptor 7 in the deep inside of the quartz cylinder 2, and the position of the susceptor 7 is adjusted so that the susceptor 7 is within the crystal growth temperature.

### 2. Preparation for deposition

As a raw material 5, IrO₂ powder was placed on the raw material mount 4, and as a substrate 6, a sapphire substrate was placed on the susceptor 7. Next, a temperature of the heater 3 was raised up to 850 °C, and by heating IrO₂ powder placed on the raw material mount 4 sublimating IrO₂ powder to produce a gaseous iridium oxide.

### 3. Deposition

A carrier gas was supplied into the quartz cylinder 2 from a carrier gas supply source while maintaining the temperature of the heater 3 at 850°C, to supply the metal oxide gas (gaseous iridium oxide) generated in the above 2. to the substrate 6 through the quartz cylinder 2. The flow rate of the carrier gas was 1.0L/min, and oxygen was used as the carrier gas. The metal oxide gas was reacted in a vicinity of a surface of the substrate 6 under atmospheric pressure, and a film was formed on the substrate. A deposition time was 60 minutes, and a film thickness was 220nm. Further, the substrate temperature at the time of deposition was 600 °C.

### 4. Evaluation

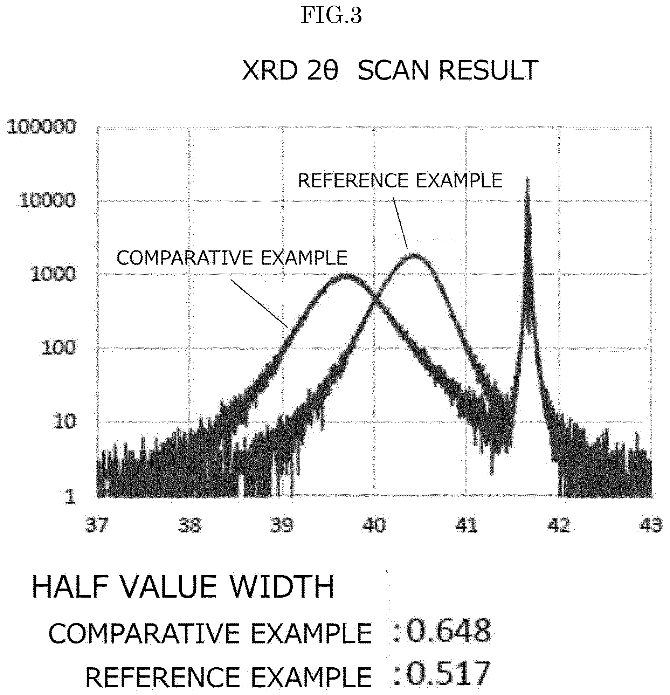

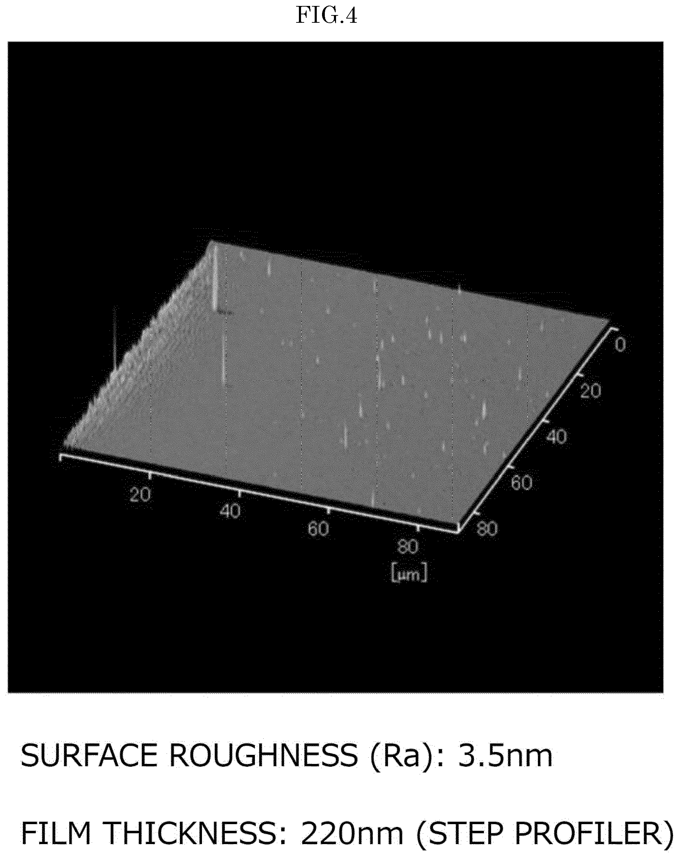

Using an X-ray diffraction device (XRD), a phase of the film obtained at 3. described above was identified and revealed to be α-Ir₂O₃ film. The result of XRD are illustrated in Fig.3. Also, Hall effect of the obtained α-Ir₂O₃ film was measured and revealed that the α-Ir₂O₃ film had an F-value that was 0.998 and a carrier type was "p" that means a p-type semiconductor. A carrier concentration of the film was 1.05×10²² (/cm³) and a carrier mobility was 3.12 (cm²/V·s).
Further, a surface of the film was observed using atomic force microscopy (AFM), and found that a surface roughness (Ra) was 3.5 nm, as illustrated in Fig.4. The film had excellent surface smoothness as illustrated in Fig.3. Here, the surface roughness (Ra) was calculated based on JIS B0601 using a result of surface shapes measurement for an area of 90µm square by atomic force microscopy (AFM).

### (Comparative Example 1)

### 1. Deposition apparatus

With reference to Fig.2, a mist CVD apparatus used in the comparative example is described. The mist CVD apparatus 19 includes a susceptor 21 on which a substrate 20 is placed, a carrier gas supply device 22a to supply a carrier gas, a flow control valve 23a that is configured to control a flow rate of the carrier gas supplied from the carrier gas supply device 22a, a carrier gas (diluted) supply device 22b to supply a carrier gas (diluted), a flow control valve 23b that is configured to control a flow rate of the carrier gas supplied from the carrier gas (diluted) supply device 22b, a mist generator 24 containing a raw material solution 24a, a container 25 containing water 25a, an ultrasonic transducer 26 attached to a bottom of the container 25, a supply pipe 27 made of a quartz tube having an inner diameter of 40mm, and a heater 28 arranged at a peripheral portion of the supply pipe 27. The susceptor 21 is made of quartz. The susceptor 21 includes a surface that is slanted off the horizontal and on that the substrate is arranged. Since the susceptor 21 and the supply pipe 27 that is configured to be a deposition chamber are made of quartz, impurities from the device that is introduced into a film formed on the substrate 20 is suppressed.

### 2. Preparation of a raw material solution

An aqueous solution is prepared as a raw material solution by adding Iridium chloride (iridium concentration: 0.1mol/L) and gallium bromide (gallium concentration: 0.1mol/L) into ultrapure water, and hydrochloric acid was added at a volume ratio of 20%. The volume ratio of iridium chloride to gallium bromide was 19:1.

### 3. Preparation for deposition

The raw material solution 24a obtained at 2. Preparation of the Raw-Material Solution above was set in the mist generator 24. Then, as a substrate 20, a c-plane sapphire substrate was placed on the susceptor 21, and the heater 28 was activated to raise the temperature of the heater 28 up to 750°C. The first flow-control valve 23a and the second flow-control valve 23b were opened to supply carrier gas from the gas supply device 22a and the diluted carrier gas supply device 22b, which are the source of carrier gas, into the deposition chamber 27 to replace the atmosphere in the deposition chamber 27 with the carrier gas sufficiently. After the atmosphere in the deposition chamber 27 was sufficiently replaced with the carrier gas, the flow rate of the carrier gas from the carrier gas device 22a was regulated at 1.0 L/min, and the diluted carrier gas from the diluted carrier gas supply device 22b was regulated at 0.5 L/min. In this embodiment, oxygen was used as the carrier gas.

### 4. Deposition

The ultrasonic transducer was then vibrated, and the vibration was propagated through the water 25a to the raw material solution 24a to atomize the raw material solution 24a to form mist. The mist was carried by the carrier gas and introduced in the deposition chamber 27. The mist was thermally reacted at 750°C under atmospheric pressure in the deposition chamber 27 to form a film on the substrate 20. A film thickness was 280nm.

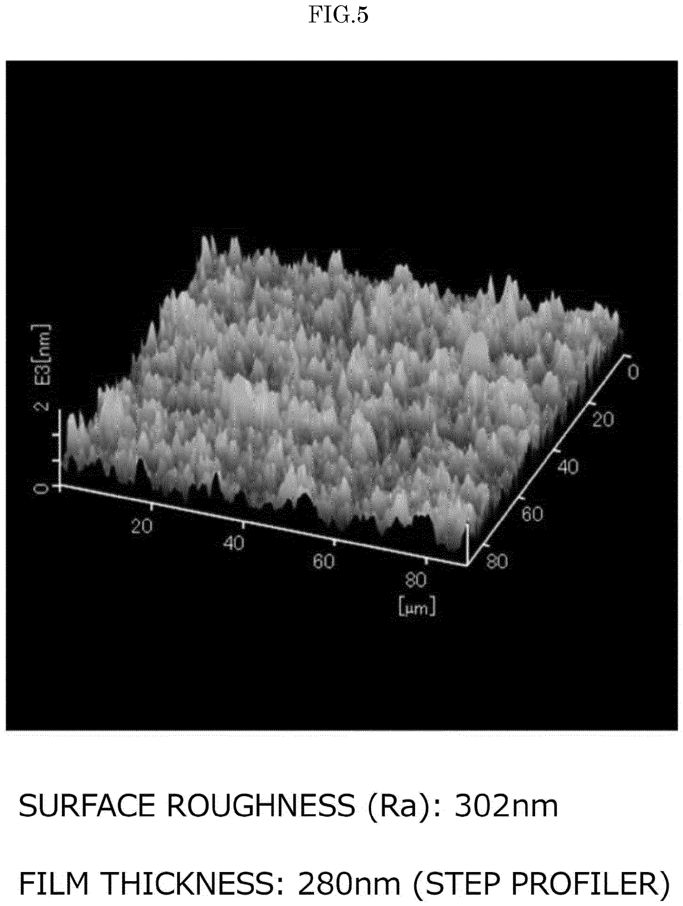

Using an X-ray diffraction device (XRD), a phase of the film obtained at 4. described above was identified and revealed to be α-Ir₂O₃ film. The result of XRD are illustrated in Fig.3. Also, Hall effect of the obtained α-Ir₂O₃ film was measured and revealed that the α-Ir₂O₃ film had an F-value that was 0.998 and a carrier type was "p" that means a p-type semiconductor. A carrier concentration of the film was 2.97×10²¹ (/cm³) and a carrier mobility was 0.38 (cm²/V·s).
Further, a surface of the film was observed using atomic force microscopy (AFM), and found that a surface roughness (Ra) was 302 nm, as illustrated in Fig.5. The film had excellent surface smoothness as illustrated in Fig.3. Here, the surface roughness (Ra) was calculated based on JIS B0601 using a result of surface shapes measurement for an area of 90µm square by atomic force microscopy (AFM).

### (Example 2 and Comparative Example 2)

As example 2 and comparative example 2, films were obtained by a method similar to the method in Example 1 and Comparative Example 1 respectively, except for a deposition time that was set to be longer. A cross sections of the obtained films were observed by using SEM. The results were illustrated in Fig.6. As apparent from Fig.6, the film obtained in example 2 is in a form of a film, whereas the film obtained in comparative example 2 grows in a form of a needle and is not in a form of a homogeneous film.

From the results of Examples and Comparative Examples, it can be said that the p-type oxide semiconductor film of the disclosure is excellent in film quality such as surface smoothness and crystallinity, and is therefore industrially useful. It can be also said that the p-type oxide semiconductor film of the disclosure excellent in electrical properties such as carrier mobility.

### (Example 3)

A p-type oxide semiconductor film was obtained by a method similar to the method in example 1, except for a deposition time that was set to be 2 hours. Next, an n--type semiconducting layer was formed on the p-type oxide semiconductor film. The n--type semiconductor layer was formed by a method similar to the method in comparative example 1, except for following conditions: gallium bromide (gallium concentration: 0. 1mol/L) was mixed in ultrapure water and hydrobromic acid was added at a volume ratio of 20% obtain an aqueous solution as a raw material solution; a temperature of the heater was set to 420°C; and a deposition time was set to 30 minutes. The obtained film was an α-Ga₂O₃ film.
Further, an n+-type semiconductor layer was formed on the obtained n--type semiconductor layer. The n+-type semiconductor layer was formed by a method similar to the method in the comparative example except for following conditions: gallium bromide (gallium concentration 0.1mol/L) was mixed with ultrapure water, hydrobromic acid was added at a volume ratio of 10% and germanium oxide was added at a ratio of 1% to obtain an aqueous solution as a raw material solution; a temperature of the heater was 390 °C; and a deposition time was 30 minutes.
Ti was deposited by sputtering on the obtained n+-type semiconductor layer, then photolithography and etching were conducted to make a p-n diode. I-V measurement was performed for the obtained p-n diode. The results are illustrated in Fig.19. As apparent from Fig19, the p-type oxide semiconductor film of the disclosure is able to realize a preferable PN junction together with a low-loss and high voltage n-type semiconductor that has high dielectric breakdown field strength (for example, gallium oxide).

### (Example 4)

### 1. Deposition apparatus

With reference to Fig.20, a deposition apparatus used in this embodiment is described. The deposition apparatus 10 illustrated in Fig.20 includes a quartz cylinder 2 which is connected to the carrier gas supply source, and a quartz raw material mount 4 that is provided in the quartz cylinder 2. The raw material 5 is placed on the raw material mount 4. A cylindrical heater (raw material side) 3a and a cylindrical heater (substrate side) 3b are respectively provided on an outer cylinder of the quartz cylinder 2 around the raw material installation mount and is configured to be able to heat the raw material 5. Further, a quartz substrate base is provided as a susceptor 7 in the deep inside of the quartz cylinder 2, and the position of the susceptor 7 is adjusted so that the susceptor 7 is within the crystal growth temperature.

### 2. Preparation for deposition

As a raw material 5, IrO₂ powder was placed on the raw material mount 4, and as a substrate 6, a sapphire substrate was placed on the susceptor 7. Next, a temperature of the heater (raw material side) 3a was raised up to 850 °C, and by heating IrO₂ powder placed on the raw material mount 4 sublimating IrO₂ powder to produce a gaseous iridium oxide. A temperature of the heater (substrate side) 3b was raised up to 350 °C.

### 3. Deposition

A carrier gas was supplied into the quartz cylinder 2 from a carrier gas supply source while maintaining the temperature of the heater (raw material side) 3 at 850 °C and the temperature of the heater (substrate side) at 350 °C, to supply the metal oxide gas (gaseous iridium oxide) generated in the above 2. to the substrate 6 through the quartz cylinder 2. The flow rate of the carrier gas was 2.0L/min, and oxygen was used as the carrier gas. The metal oxide gas was reacted in a vicinity of a surface of the substrate 6 under atmospheric pressure, and a film was formed on the substrate. A deposition time was 90 minutes.

### 4. Evaluation

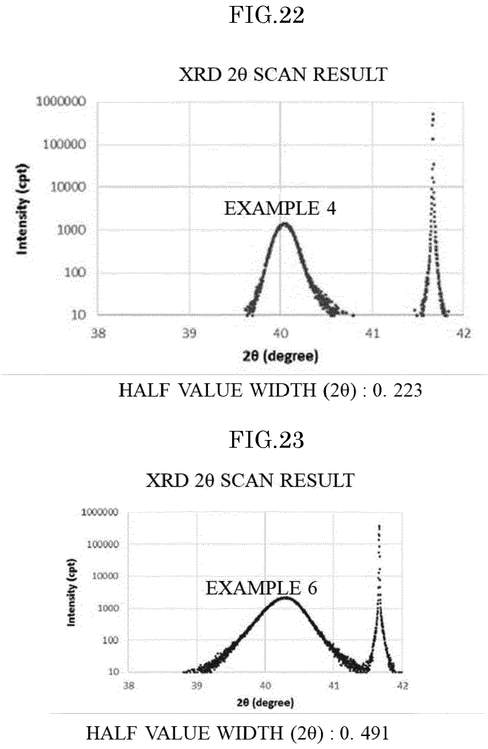

Using an X-ray diffraction device (XRD), a phase of the obtained film was identified and revealed to be α-Ir₂O₃ film. The result of XRD are illustrated in Fig.22. Further, a surface of the film was observed using atomic force microscopy (AFM), and found that a surface roughness (Ra) was 0.161 nm, and the film had excellent surface smoothness. Here, the surface roughness (Ra) was calculated based on JIS B0601 using a result of surface shapes measurement for an area of 90µm square by atomic force microscopy (AFM).

### (Example 5)

The p-type oxide semiconductor film was obtained by a method similar to the method in the example 4, except for following conditions; a temperature of the heater (substrate side) was set to be 250 °C; a flow rate of the carrier gas was set to be 4.0 L/min; and a deposition time was set to be 120 minutes. Using an X-ray diffraction device (XRD), a phase of the obtained film was identified and revealed to be α-Ir₂O₃ film. Also, the obtained film had excellent surface smoothness as example 4. Further, Hall effect of the obtained α-Ir₂O₃ film was measured and revealed that the α-Ir₂O₃ film had an F-value that was 0.999 and a carrier type was "p" that means a p-type semiconductor. A carrier concentration of the film was 1.64×10²¹ (/cm³) and a carrier mobility was 1.63 (cm²/V·s).

### (Example 6)

### 1. Deposition apparatus equipment

With reference to Fig.21, a deposition apparatus used in the comparative example is described. The deposition apparatus 30 includes a susceptor 21 on which a substrate 20 is placed, a carrier gas supply device 22a to supply a carrier gas, a flow control valve 23a that is configured to control a flow rate of the carrier gas supplied from the carrier gas supply device 22a, a carrier gas (diluted) supply device 22b to supply a carrier gas (diluted), a flow control valve 23b that is configured to control a flow rate of the carrier gas supplied from the carrier gas (diluted) supply device 22b, a mist generator 24 containing a raw material solution 24a, a container 25 containing water 25a, an ultrasonic transducer 26 attached to a bottom of the container 25, a supply pipe 27 made of a quartz tube having an inner diameter of 40mm, and a heater (raw material side) 28a and a heater (substrate side) 28b that are arranged at a peripheral portion of the supply pipe 27. The supply pipe 27 is configured by 2 zones including a supply pipe (raw material side) 27a where the heater (raw material side) 28a is provided and a supply pipe (substrate side) 27b where the heater (substrate side) 28b is provided. The susceptor 21 is made of quartz. The susceptor 21 includes a surface that is slanted off the horizontal and on that the substrate is arranged. Since the susceptor 21 and the supply pipe 27 that is configured to be a deposition chamber are made of quartz, impurities from the device that is introduced into a film formed on the substrate 20 is suppressed.

### 2. Preparation of a raw material solution

An aqueous solution is prepared as a raw material solution by adding iridium bromide (iridium concentration: 0.1mol/L) into ultrapure water, and 48% hydrobromic acid was added.

### 3. Preparation for deposition

The raw material solution 24a obtained at 2. Preparation of the Raw-Material Solution above was set in the mist generator 24. Then, as a substrate 20, a c-plane sapphire substrate was placed on the susceptor 21, the heater (raw material side) 28a was activated to raise a temperature of the heater (raw material side) 28a up to 950°C, and the heater (substrate side) 28b was activated to raise a temperature of the heater (substrate side) 28b up to 350°C. The first flow-control valve 23a and the second flow-control valve 23b were opened to supply carrier gas from the gas supply device 22a and the diluted carrier gas supply device 22b, which are the source of carrier gas, into the deposition chamber 27 to replace the atmosphere in the deposition chamber 27 with the carrier gas sufficiently. After the atmosphere in the deposition chamber 27 was sufficiently replaced with the carrier gas, the flow rate of the carrier gas from the carrier gas device 22a was regulated at 1.0 L/min, and the diluted carrier gas from the diluted carrier gas supply device 22b was regulated at 0.5 L/min. In this embodiment, oxygen was used as the carrier gas.

### 4. Deposition

The ultrasonic transducer was then vibrated, and the vibration was propagated through the water 25a to the raw material solution 24a to atomize the raw material solution 24a to form mist. The mist was carried by the carrier gas and introduced in the supply pipe 27a, and the mist was evaporated and oxidized to produce a gaseous iridium oxide. The obtained metal oxide gas (gaseous iridium oxide) was carried on the substrate 20 in the supply pipe 27b, and then, the metal oxide gas thermally reacted at 350°C under atmospheric pressure in the vicinity of the substrate 20 to deposit on the substrate 20. A deposition time was 60 minutes.

### 5. Evaluation

Using an X-ray diffraction device (XRD), a phase of the film obtained at 4. described above was identified and revealed to be α-Ir₂O₃ film. The result of XRD are illustrated in Fig.23. Also, Hall effect of the obtained α-Ir₂O₃ film was measured and revealed that the α-Ir₂O₃ film had an F-value that was 1.000 and a carrier type was "p" that means a p-type semiconductor. A carrier concentration of the film was 1.12×10²² (/cm³) and a carrier mobility was 1.60 (cm²/V·s). Further, a surface of the film was observed using atomic force microscopy (AFM), and found that a surface roughness (Ra) was 9.433 nm, and the film had excellent surface smoothness. Here, the surface roughness (Ra) was calculated based on JIS B0601 using a result of surface shapes measurement for an area of 90µm square by atomic force microscopy (AFM).

From the results of Examples 4 to 6, it can be seen that the p-type oxide semiconductor film obtained by the method of the disclosure is excellent in film quality such as surface smoothness and crystallinity, and is therefore industrially useful. It can be also said that the p-type oxide semiconductor film of the disclosure excellent in electrical properties such as carrier mobility.

### INDUSTRIAL APPLICABILITY

The p-type oxide semiconductor film of the disclosure is applicable as semiconductors (e.g., compound semiconductor electronic devices, etc.), electric components and electronic devices, optical and electronic photography related devices, and industrial parts. Since the p-type oxide semiconductor film of the disclosure has an enhanced p-type semiconductor property, the p-type oxide semiconductor film is, particularly useful for semiconductor devices.

### EXPLANATION OF NUMBERS

- 1: deposition apparatus
- 2: quartz cylinder
- 3: heater
- 4: raw material mount
- 5: raw material
- 6: substrate
- 7: susceptor
- 11a: first n +-type semiconductor layer
- 11b: second n +-type semiconductor layer
- 12: n-type semiconductor layer
- 13: p-type semiconductor layer
- 14: a gate electrode
- 14b: source electrode
- 14c: drain electrode
- 15: gate insulating film
- 16: p+-type semiconductor layer
- 19: mist CVD equipment
- 20: substrate
- 21: susceptor
- 22a: carrier gas supply device
- 22b: carrier gas (diluted) supply device
- 23a: flow control valve
- 23b: flow control valve
- 24: mist generator
- 24a: raw material solution
- 25: container
- 25a: water
- 26: ultrasonic transducer
- 27: supply pipe
- 27a: supply pipe (raw material side)
- 27b: supply pipe (substrate side)
- 28: heater
- 29: air outlet
- 40: sub-collector layer
- 42: collector layer
- 44: base layer
- 46: emitter layer
- 48: cap layer
- 52: collector electrode
- 54: base electrode
- 56: emitter electrode
- 60: substrate
- 101a: n--type semiconductor layer
- 101b: n+-type semiconductor layer
- 102: p-type semiconductor layer
- 103: metal layer
- 104: insulating layer
- 105: Schottky electrode
- 105b: Ohmic electrode
- 121a: n-type semiconductor layer with wide bandgap
- 121b: n-type semiconductor layer with narrow band gap
- 121c: n+-type semiconductor layer
- 123: p-type semiconductor layer
- 125a: gate electrode
- 125b: source electrode
- 125c: drain electrode
- 128: buffer layer
- 129: substrate
- 131a: n--type semiconductor layer
- 131b: first n +-type semiconductor layer
- 131c: second n +-type semiconductor layer
- 132: p-type semiconductor layer
- 134: gate insulating film
- 135a: gate electrode
- 135b: source electrode
- 135c: drain electrode
- 138: buffer layer
- 139: semi-insulating layer
- 141a: n--type semiconductor layer
- 141b: first n +-type semiconductor layer
- 141c: second n +-type semiconductor layer
- 142: p-type semiconductor layer
- 145a: gate electrode
- 145b: source electrode
- 145c: drain electrode
- 151: n-type semiconductor layer
- 151a: n--type semiconductor layer
- 151b: n+-type semiconductor layer
- 152: p-type semiconductor layer
- 154: gate insulating film
- 155a: gate electrode
- 155b: emitter electrode
- 155c: collector electrode
- 161: n-type semiconductor layer
- 162: p-type semiconductor layer
- 163: Luminescent layer
- 165: a first electrode
- 165b: second electrode
- 167: translucent electrode
- 169: substrate

## Claims

1. An oxide semiconductor film having a p-type electrical conductivity and includes as a major component a metal oxide having a corundum structure, and wherein a surface roughness of the oxide semiconductor film is equal to or less than 100 nm.

2. The oxide semiconductor film of claim 1,
wherein a thickness of the oxide semiconductor film is equal to or more than 50 nm.

3. The oxide semiconductor film of claim 1,
wherein the thickness of the oxide semiconductor film is equal to or more than 100 nm.

4. The oxide semiconductor film of any one of claims 1 to 3,
wherein the metal oxide includes a d-block metal in the periodic table or a metal of Group 13 of the periodic table.

5. The oxide semiconductor film of any one of claims 1 to 4,
wherein the metal oxide includes a metal of Group 9 of the periodic table or the metal of Group 13 of the periodic table.

6. The oxide semiconductor film of any one of claims 1 to 5,
wherein the metal oxide includes iridium.

7. The oxide semiconductor film of any one of claims 1 to 6,
wherein the surface roughness of the oxide semiconductor film is equal to or less than 10 nm.

8. The oxide semiconductor film of any one of claims 1 to 7,
wherein a carrier mobility of the oxide semiconductor film is equal to or more than 1.0 cm²/V·s.

9. The oxide semiconductor film of any one of claims 1 to 8,
wherein a carrier concentration of the oxide semiconductor film is equal to or less than 8×10²⁰/cm³.

10. A method of forming a p-type oxide semiconductor film comprising:
using a metal oxide gas, and
conducting a crystal growth on a base having a corundum structure.

11. The method of claim 10,
wherein the metal oxide gas includes a metal of Group 9 of the periodic table or a metal of Group 13 of the periodic table.

12. The method of claim 10 or 11,
wherein the metal oxide gas includes the metal of Group 9 of the periodic table.

13. The method of any one of claims 10 to 12,
wherein the metal oxide includes at least iridium.

14. The method of any one of claims 10 to 13,
wherein a solid-state metal oxide is heated to sublimate into the metal oxide gas.

15. The method of any one of claims 10 to 14,
wherein the crystal growth is conducted under atmospheric pressure.

16. A semiconductor device comprising:
a semiconductor layer having an oxide semiconductor film of any one of claims 1 to 9, and
an electrode.

17. The semiconductor device of claim 16, further comprising
an n-type semiconductor layer including an oxide semiconductor as a major component.

18. The semiconductor device of claim 16 or 17,
wherein the n-type semiconductor layer includes a metal of Group 13 of the periodic table.

19. The semiconductor device of any one of claims 16 to 18,
wherein the semiconductor device is a diode or a transistor.

20. The semiconductor device of any one of claims 16 to 19,
wherein the semiconductor device is SBD, MOSFET, IGBT or JFET.

21. The semiconductor device of any one of claims 16 to 20, further comprising
a semiconductor-on-insulator (SOI) structure,
wherein the SOI structure includes a silicon substrate, and
an insulating layer that is embedded on the silicon substrate.

22. The semiconductor device of claims 16 to 21,
wherein the semiconductor device is a power device.

23. The semiconductor device of claims 16 to 22,
wherein the semiconductor device is a power module, an inverter, or a converter.

24. A semiconductor system comprising:
the semiconductor device of any one of claims 16 to 23.
